(19) Europäisches Patentamt
European Patent Office
Office européen des brevets

(11) EP 1 312 697 A1

(12) **EUROPEAN PATENT APPLICATION**

(43) Date of publication:
**21.05.2003 Bulletin 2003/21**

(51) Int Cl.[7]: **C23C 16/40**, C23C 16/34, C23C 16/30

(21) Application number: **02257838.9**

(22) Date of filing: **13.11.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: **16.11.2001 US 332397 P**
**25.03.2002 US 106677**

(71) Applicant: **ASML US, Inc.**
**Scotts Valley, CA 95066 (US)**

(72) Inventors:
- **Senzaki, Yoshihide**
**California 95003 (US)**
- **Herring, Robert B.**
**California 95129-4039 (US)**
- **Helms, Aubrey L.**
**California 95032 (US)**
- **Osborne, Nick J.**
**California 97024 (US)**

(74) Representative: **Stoner, Gerard Patrick et al**
**MEWBURN ELLIS**
**York House**
**23 Kingsway**
**London WC2B 6HP (GB)**

(54) **CVD of dielectric films**

(57) A method of depositing dielectric films such as silicon nitride, oxide, oxynitride, and multilayer films on the surface of a substrate is provided. The method comprises providing a substrate in a hot-wall rapid thermal processing chamber, and using a silicon precursor to form a dielectric film on the substrate.

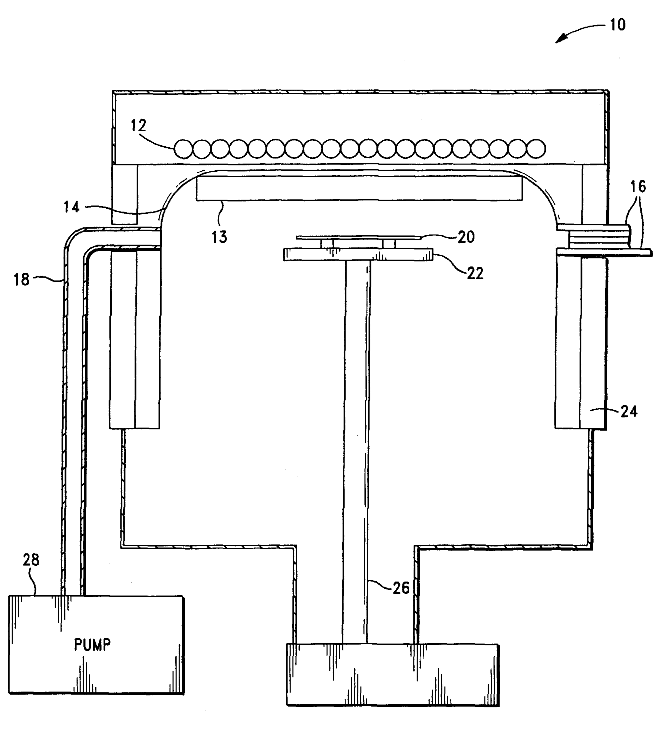


*FIG. 1*

EP 1 312 697 A1

## Description

## CROSS REFERENCE TO RELATED APPLICATION

This application claims priority to the United States Provisional Application No. 60/332,397 filed November 16, 2001, and the United States Patent Application No. 10/106,677 filed March 25, 2002, the disclosures of which are herein incorporated by reference in their entirety.

The present invention relates generally to semiconductor processing, and more particularly to a system and method for depositing thin dielectric films on a substrate in a low pressure hot-wall rapid thermal processing system.

## BACKGROUND

Future generation of semiconductor devices requires thin dielectric films for MOS transistor gate and capacitor dielectrics. As the size of integrated circuit devices is scaled down, conventional dielectrics such as silicon dioxide ($SiO_2$), reach its physical limitation. For instance, below the thickness of 20 Angstroms, the $SiO_2$ gate dielectric no longer functions as an insulator due to direct current tunneling leakage. Thus, $SiO_2$ dielectrics are rapidly becoming one of the limiting factors in device design and manufacturing, and new dielectric materials with high dielectric constant are actively being sought to provide high capacitance without compromising gate leakage current.

Silicon nitride ($Si_3N_4$) has been considered as one of the alternatives to silicon oxide as a transistor gate and capacitor dielectrics. With a dielectric constant of about 8, which is nearly twice that of silicon oxide, silicon nitride can be fabricated with a greater thickness than a comparable oxide layer while still achieving the same capacitance. A thicker film is easier to manufacture than a thin film and leads to better electrical properties, such as lower leakage current, higher breakdown, and more resistant to boron (dopant) penetration, etc. Thickness uniformity control of sub 20Å thickness nitride films is crucial as the equivalent oxide thickness (EOT) of future gate dielectrics is required to be less than 15Å.

Silicon nitride films are conventionally fabricated in batch furnaces from dichlorosilane (DCS) and ammonia at low pressure. While each batch can process a plurality of substrates at one time, the deposition rate is quite low, e. g., about 5-10Å per minute. Rapid thermal processing (RTP) is an emerging technology in integrated circuit (IC) fabrication and a potential substitute for conventional batch furnace processing. RTP needs shorter process cycle time and provides better temperature control which can assist in achieving higher throughput and better film uniformity. RTP has potential to be as competitive as advanced batch process as future wafer production moves to 300 mm diameter size. The known applications of RTP include thin gate dielectric formation, ion implantation anneal, polysilicon chemical vapor deposition (CVD), and titanium or cobalt silicide formation.

U.S. Patent No. 5,932,286 describes a method of depositing silicon nitride films in a cold-wall rapid thermal CVD (RTCVD) system where external lamps are used as heating sources. One problem with the cold-wall RTCVD system for the use of dichlorosilane is the formation of solid ammonium chloride ($NH_4Cl$) as a product of the following condensation reaction which occurs during the depositing process:

$$3\ SiH_2Cl_2 + 10\ NH_3 \rightarrow Si_3N_4 + 6\ NH_4Cl + 6\ H_2$$

The formation of solid $NH_4Cl$ degrades the electrical properties of the deposited films and reduces the throughput of the deposition process. To avoid this problem, prior art cold-wall RTCVD systems commonly use silane as silicon sources which do not contain chlorine. Silane-based nitride films are generally deposited by thermal CVD at 700-900°C or by plasma enhanced CVD (PECVD) at 200-400°C which requires a high gas flow ratio of $NH_3$ to $SiH_4$ for stoichiometry control of $Si_3N_4$. Moreover, capacitor applications often require non-planar device configuration where conformality of the capacitor layer is important. The conformality of silane-based nitride films is inferior to that of dichlorosilane (DCS) based nitride films. Further, the films deposited from silane contain a significant amount of hydrogen, typically about 10 atomic% or above, which degrades the electrical properties of the nitride films. In addition, silane-based nitride films deposited on silicon substrates by PECVD have a poor interface with silicon and is electronically leaky due to a high trap density at the interface. As a result, DRAM storage capacitors suffer uniformity and leakage limitations at about 3.5-4.0 nm when silicon nitride films deposited by prior art methods are used for dielectrics. Accordingly, improved systems and processes for the formation of dielectric films are needed.

Accordingly, it is an object of the present invention to provide a system and method for depositing dielectric films for gate, capacitor, and other IC device dielectrics.

It is another object of the present invention to provide a system and method for depositing dielectric films using chlorine containing silicon sources to provide superior electrical properties for these films.

In one aspect we propose a deposition method using a low pressure hot-wall rapid thermal processing system.

In one specific aspect, a method of depositing a silicon nitride film on the surface of a substrate is provided. The method comprises providing a substrate in a hot-wall thermal processing chamber, adjusting the pressure of the processing chamber to a range preferably from about 0.01 to 10 Torr, and reacting a chlorine containing silicon precursor with ammonia at a temperature preferably in a range of 550°C to 900°C to form a silicon nitride film on the substrate. The chlorine containing silicon precursor may be selected from the group of $SiH_2Cl_2$, $SiH_3Cl$, $SiHCl_3$, $SiCl_4$, and $Si_2Cl_6$. Preferably the chlorine containing silicon precursor is dichlorosilane $SiH_2Cl_2$ (DCS). The ratio of chlorine containing silicon precursor to ammonia is preferably from about 1:3 to 1:10.

In another specific aspect, a method of depositing a high temperature silicon oxide (HTO) film on the surface of a substrate is provided. The method comprises providing a substrate in a hot-wall rapid thermal processing chamber, adjusting the pressure of the processing chamber to a range from about 0.01 Torr to 10 Torr, and reacting a silicon precursor with an oxygen containing precursor such as $N_2O$, NO, $O_2$, or any combination thereof, at a temperature in a range from about 550°C to 1000°C to form a silicon oxide film on the substrate. The silicon precursor maybe selected from the consisting of $SiH_2Cl_2$, $SiH_3Cl$, $SiClH_3$, $SiCl_4$, $Si_2Cl_6$, $SiH_4$, $Si(OC_2H_5)_4$, and aminosilane. Preferably the silicon precursor is $SiH_2Cl_2$ (DCS). The ratio of the silicon precursor to the oxygen containing gas is preferably in a range from about 1:3 to 1:10.

In a further specific aspect, a method of depositing an oxynitride film on the surface of a substrate is provided. The method comprises providing a substrate in a hot-wall rapid thermal processing chamber, adjusting the pressure of the hot-wall deposition chamber to a range from about 0.1 Torr to 10 Torr, and reacting a silicon precursor with a mixture of ammonia and $N_2O$ at a temperature in a range from about 550 to 1000°C to form an oxynitride film on the substrate. The silicon precursor may be selected from the group of $SiH_2Cl_2$, $SiH_3Cl$, $SiClH_3$, $SiCl_4$, $Si_2Cl_6$, $SiH_4$. $Si(OC_2H_5)_4$, and aminosilane, with $SiH_2Cl_2$ (DCS) being preferred. The ratio of silicon precursors to the mixture of $NH_3$ and $N_2O$ is preferably from about 1:3 to 1:10.

In still another specific aspect of the present invention, there is provided a method of depositing a multilayer of silicon oxide and silicon nitride film on the surface of a substrate. The method comprises providing a substrate in a hot-wall rapid thermal processing chamber, adjusting the pressure of the processing chamber to a range from about 0.01 to 10 Torr, reacting a silicon containing precursor with an oxygen containing precursor such as $N_2O$, NO, $O_2$, or any combination thereof, at a temperature in a range from about 550°C to 1000°C to form a silicon oxide film on the substrate, and reacting a silicon precursor with ammonia at a temperature in a range from about 550°C to 900°C to form a silicon nitride atop the silicon oxide film.

The above-mentioned pressure and temperature ranges are generally applicable in the present methods, separately or combined.

## BRIEF DESCRIPTION OF THE DRAWINGS

These and other features of the present proposals will become better understood upon reading the following detailed description of embodiments and upon reference to the drawings, in which:

FIG. 1 schematically shows a low pressure hot-wall rapid thermal processing reactor according to one embodiment of the present invention.

FIG. 2 is a graph illustrating the deposition rate of silicon nitride ($Si_3N_4$) from dichlorosilane (DCS) and ammonia ($NH_3$) with DSC:$NH_3$ ratio of 1:3 at pressure of 0.5 Torr according to one embodiment of the present invention.

FIG. 3 is a graph illustrating the repeatability test for depositing 40Å $Si_3N_4$ films on 10 wafers with respect to the thickness and uniformity of the films according to one embodiment of the present invention.

FIG. 4 is a cross sectional SEM photograph showing $Si_3N_4$ films deposited on a patterned substrate according to one embodiment of the present invention.

FIG. 5 is a graph illustrating the repeatability test for growing 20Å dry oxide films with respect to the thickness and uniformity of the films according to one embodiment of the present invention.

FIG. 6 is a graph illustrating SIMS depth profile of a 25Å dry oxide film grown in nitric oxide (NO) followed by reoxidation at 1050°C.

FIG. 7 is an AES depth profile of a 170Å high temperature oxide-silicon nitride stack film (HTO/$Si_3N_4$/HTO).

FIG. 8 is a graph illustrating the current density verses the equivalent oxide thickness (EOT) of oxide/nitride films formed by the present invention and films formed by prior art methods.

FIGs. 9A and 9B are graphs illustrating C-V and I-V curves respectively for a film deposited on wafer No. 15 in Table 3 according to one embodiment of the present invention.

FIGs. 10A and 10B are graphs illustrating C-V and I-V curves respectively for a film deposited on wafer No. 13 in Table 3 using prior art methods.

FIGs. 11A and 11B are graphs illustrating C-V and I-V curves respectively for a film deposited on wafer No. 9 in Table 4 according to one embodiment of the present invention.

FIG. 12 is a graph illustrating the current density verses the EOT of the nitride or oxide films formed on wafers No. 1-13 in Table 4 according to one embodiment of the present invention.

FIG. 13 is a graph illustrating Vfb verses anneal temperature curve for the films deposited on wafers No 1-6 in Table 5 according to one embodiment of the present invention.

FIGS. 14-19 are graphs illustrating V-C curves for the films deposited on wafers No. 1-6 respectively in Table 5 according to one embodiment of the present invention.

## DETAILED DESCRIPTION

FIG. 1 schematically shows a low pressure hot-wall rapid thermal processing reactor 10 according to one embodiment of the present invention. The hot-wall RTP reactor 10 comprises a chamber 14 into which a single substrate 20 is loaded. The wall of the chamber 14 is preferably made of quartz. A plurality of heating elements 12 are provided adjacent to the upper end of the chamber 14. Suitable heating elements include resistive heating elements coupled with a power source controlled by a computer (not shown). An isothermal plate 13, preferably made of quartz, is disposed inside and adjacent to the upper end of the chamber 14. The heating elements 12 and isothermal plate 13 serve as heating sources for the use of the RTP reactor 10. The isothermal plate 13 can be placed in the chamber 14 or on the top of chamber 14. The isothermal plate 13 receives heat rays radiated from the heating elements 12 and radiates secondary heat rays into the chamber 14. The isothermal plate 13 can produce a more uniform thermal distribution on the surface of the substrate 20.

The hot-wall RTP reactor 10 further comprises one or more insulation sidewalls 24 adjacent to the sidewall of chamber 14. Heating means (not shown) are provided between the insulation sidewalls 24 and the sidewall of the chamber 14 to heat the sidewall of the chamber 14 to achieve a more accurate control over the temperature within the chamber 14.

The single substrate 20 is supported by a platform 22 which is coupled with an elevator 26 for moving the substrate 20 into and out of the chamber 14. One or more gas inlets 16 are disposed at the sidewall of the chamber 14 and connected to one or more gas manifolds (not shown) which convey a gas or a mixture of gases into the chamber 14. The gas concentration and flow rates through each of the gas inlets 16 are selected to produce reactant gas flows and concentration that optimize processing uniformity. An exhaust line 18 is provided at the sidewall of the chamber 14 opposite the gas inlets 16 and connected to a pump 28 for exhausting the chamber 14. While one specific hot-wall RTP reactor has been described the invention is not limited to this specific design, and other, hot-wall RTP reactors may be employed in the present invention.

In one embodiment, the present invention provides a method of depositing a silicon nitride ($Si_3N_4$) film on the surface of a substrate by reacting a chlorine-containing silicon precursor and ammonia using a low pressure hot-wall RTP reactor, such as for example the reactor shown in Fig. 1.

Suitable chlorine containing precursors used for depositing nitride films include, but are not limited to: $SiH_2Cl_2$, $SiH_3Cl$, $SiHCl_3$, $SiCl_{4,}$ $Si_2Cl_{6,}$ SiH4, and aminosilane.
Preferably, $SiH_2Cl_2$ (DCS) is used as the chlorine containing precursor. The ratio of DCS to $NH_3$ is preferably about 1:3 to 1:10, more preferably about 1:5.

The process is preferably carried out at a temperature of above about 500°C, more preferably in a range of about 550°C to 900°C, with a temperature of about 600-800°C being most preferred. The pressure of the chamber 14 of the hot-wall reactor 10 is preferably adjusted to a range of about 0.01 to 10 Torr, more preferably about 0.1 to 5 Torr.

The deposition rate of nitride film on the substrate is preferably from about 15Å/min to 150Å/min. The thickness uniformity of the nitride films can be achieved below 0.8% (1σ).

In another embodiment, the present invention provides a method of depositing a high temperature silicon oxide film on the surface of a substrate by reacting a silicon precursor and nitrous oxide ($N_2O$) and/or nitric oxide (NO) and/or $O_2$ using a low pressure hot-wall RTP reactor, such as but not limited to that shown in Fig. 1.

Suitable silicon precursors used for depositing oxide films include, but are not limited to: $SiH_2Cl_2$, $SiH_3Cl$, $SiClH_3$, $SiCl_4$, $Si_2Cl_6$, $SiH_4$, $Si(OC_2H_5)_{4,}$ (TEOS) and aminosilane. Preferably $SiH_2Cl_2$ (DCS) is used as silicon precursor. The ratio of DCS to $N_2O$ and/or NO and/or $O_2$ is preferably about 1:3 to 1:10, more preferably about 1:5.

The process is preferably carried out at a temperature in a range from about 550 to 1000°C, more preferably from about 600°C to 900°C, most preferably from about 700 to 900°C. The pressure of the chamber 14 of the hot-wall RTP reactor 10 is preferably adjusted to a range from about 0.01 to 10 Torr, more preferably from 0.1 to 5 Torr.

The inventors have found that nitrogen can be incorporated in the thin oxides to improve the gate oxide properties. In particular, and of significant advantage, one embodiment of the present invention provides for incorporation of nitrogen into the film which the inventors have found to enhance the suppression of boron penetration from the polysilicon gate and enhances the device reliability. However, the amount of nitrogen incorporated into oxide films should be carefully controlled since excessive amount of nitrogen at the interface between the oxide film and the silicon substrate may degrade device performance. Preferably the nitrogen is incorporated in an amount from about 1 to 10 peak atomic%.

In another embodiment, the present invention provides a method of depositing oxynitride films on the surface of a substrate by reacting a silicon precursor with a mixture of $NH_3$ and $N_2O$ using a hot-wall RTP reactor such as but not limited to the reactor 10 shown in Fig. 1.

Suitable silicon precursors used in the present method include $SiH_2Cl_2$, $SiH_3Cl$, $SiClH_3$, $SiCl_4$, $Si_2Cl_6$, $SiH_4$, $Si(OC_2H_5)_4$, and aminosilane. Preferably $SiH_2Cl_2$ (DCS) is used as silicon precursor. The ratio of DCS to the mixture of $NH_3$ and $N_2O$ is preferably from about 1:3 to 1:10, more preferably about 1:5.

The process is preferably carried out at a temperature in a range of from about 550 to 1000°C, more preferably from about 700 to 800°C. The pressure of the chamber 14 of the hot-wall RTP reactor 10 is preferably adjusted to a range of about 0.01 to 10 Torr, more preferably from 0.1 to 5.0 Torr.

In another embodiment, the present invention provides a method of depositing a multilayer dielectric film on the surface of a substrate using the low pressure hot-wall RTP reactor 10. The method comprises firstly depositing an oxide layer on the surface of a substrate by reacting a silicon precursor with an oxygen containing precursor such as $N_2O$, NO, $O_2$, or any combination thereof, and then depositing a nitride or oxynitride layer atop the oxide layer by reacting a silicon precursor with $NH_3$ or a mixture of $NH_3$ and $N_2O$. In this embodiment, the method may further comprise depositing a third oxide layer atop the nitride layer by reacting a silicon precursor with an oxygen containing precursor.

The dielectric films made by the present invention have good electrical properties such as high breakdown voltage and low leakage current, which are required for thin insulator applications in DRAM and non-volatile memory devices. In deposition of nitride films, the hot-wall RTP reactor suppresses the formation of solid $NH_4Cl$ and thus enhance the electrical properties of the films formed.

The following examples are provided to illustrate the systems and methods of the present invention, and are not intended to limit the scope of the invention in any way. In the experiments, the film thickness, uniformity, and refractive index were measured by Ellipsometry (49 points, 3mm edge exclusion). The chemical composition of the films were analyzed using Rutherford Backscattering Spectroscopy (RBS) and Hydrogen Forward Scattering (HFS) spectroscopy. Depth profiles of the oxide/nitride/oxide stack films were analyzed by Auger Electron Spectroscopy (AES). Step coverage of the nitride films deposited on $SiO_2$ coated silicon wafers was evaluated using cross section scanning electron microscopy (SEM).

Example 1

This example illustrates low pressure chemical vapor deposition (LPCVD) of silicon nitride films from dichlorosilane (DCS) and ammonia.

40Å silicon nitride films were deposited at a wafer temperature in a range of about 695°C to 800°C with DCS: $NH_3$ ratios of 1:3 (25-75 sccm) at a pressure range below 0.5 Torr. The ten wafer continuous depositions at 735°C achieved an average thickness of 40.7Å, within-wafer uniformity of 0.55% (1σ) and wafer-to-wafer uniformity of 0.50% (1σ) as shown in Figure 3.

20Å silicon nitride films were deposited with thickness uniformity below 0.8% (1σ) at 700°C for thin gate dielectric applications.

Thicker nitride films were also grown for better accuracy in the refractive index measurement. Extended depositions up to 30 min under the above conditions provided nitride film thickness ranging from 400 to 1000Å and refractive indexes of 1.99 to 2.01, which were consistent with the literature value of 2.00 ± 0.01 for stoichiometric $Si_3N_4$. The RBS analysis revealed that the N:Si ratios in the films were approximately 1.3.

Table 1 shows the composition analysis results by Rutherford Backscattering Spectroscopy (RBS) (for Si, N, and Cl) and Hydrogen-Forward Scattering (HFS) (for H) Spectroscopies. For comparison, DCS:$NH_3$ ratio was varied from 1:3 to 1:5, the deposition temperature was varied from 730°C to 780°C, but the refractive index and N to Si ratio remained constant at or near 1.33. No significant difference in composition was observed in these films. Oxygen level in the film was below the detection limit (<1 atom.%). The level of Cl incorporation in the films decreased as the deposition temperature increased. The hydrogen incorporation in the as-deposited films was lower than that of the films deposited from silane under given conditions.

Table 1.

| DCS-Based Nitride Film Composition Analysis by RBS and HFS | | | | | | |
|---|---|---|---|---|---|---|
| Temperature (°C) | DCS:NH3 Ratio | Thickness (Å) | Refractive Index | N/Si Ratio | Cl (atom.%) | H (atom.%) |
| 730 | 1:5 | 448 | 2.00 | 1.33 | 0.30 | 3.7 |
| 735 | 1:3 | 539 | 1.99 | 1.34 | 0.22 | 3.0 |

Table 1. (continued)

| DCS-Based Nitride Film Composition Analysis by RBS and HFS | | | | | | |
|---|---|---|---|---|---|---|
| Temperature (°C) | DCS:NH3 Ratio | Thickness (Å) | Refractive Index | N/Si Ratio | Cl (atom.%) | H (atom.%) |
| 780 | 1:3 | 465 | 2.01 | 1.33 | <0.1 | 3.4 |

FIG. 2 is a Arrhenius plot that illustrates the nitride deposition rate in a range from 15Å/min at 695°C to 89Å/min at 800°C. An activation energy (Ea) of this CVD process was derived as 1.49 eV from the Arrhenius plot of the deposition rates against the reciprocal of deposition temperatures. This activation energy is comparable with the prior art value calculated from batch furnace processes, and indicates that the deposition conditions are in the surface reaction limited regime.

FIG.4 is a cross-sectional SEM of the nitride films deposited on a patterned substrate ($SiO_2$ on Si) under the condition as the above 40Å deposition at 740°C. The SEM demonstrates a conformal coverage over less than 0.1 mm wide trenches with aspect ratios up to 6.

Example 2

This example illustrates atmospheric thermal oxidation process.

20Å dry oxides films were grown at 950°C with a 30 second oxidation step. Oxide films with an average thickness of 19.5Å, within-wafer uniformity average 0.64% (1σ), and wafer-to-wafer uniformity 0.47% (1σ) were obtained. FIG. 5 is a graph illustrating the repeatability test for 20Å dry oxide films on ten wafers.

A dry oxidation in nitric oxide (NO) atmosphere was conducted at 1050°C for 20 seconds followed by an in-situ reoxidation for 85 seconds at the same temperature. This two-step process provided 25Å oxide film with thickness uniformity 0.5-0.7% (1σ).

FIG. 6 is a graph illustrating SIMS depth profile of a 25Å dry oxide film grown in NO followed by reoxidation at 1050°C. The peak amount of 3.8 % nitrogen is incorporated in the film. It shows that the nitrogen peak is located at about 20Å depth, slightly above the $SiO_2$/Si interface.

Example 3

This example illustrates in situ sequential low pressure chemical vapor deposition (LPCVD) of multilayer films (oxide/nitride/oxide) on a substrate using a hot-wall RTP reactor of the type illustrated in Fig. 1.

A multilayer film of 50Å oxide (top)/80Å nitride (middle) /40Å oxide (bottom) was deposited at 800°C by switching the reactant gases from DCS/$N_2O$ to DCS/$NH_3$, then to DCS/$N_2O$ in sequence. FIG. 7 shows an AES depth profile of the 170Å multilayer (oxide/nitride/oxide) film.

Example 4

This example illustrates multilayer dielectric films formed according to the method the present invention.

FIG. 8 is a graph illustrating current density versus the EOT of oxide/nitride films formed by the present invention and films formed by prior art methods. Table 2 lists the electrical properties of the multilayer films. FIG. 8 and Table 2 show that the DCS-based nitride films fabricated for thin gate oxide-nitride (ON) stack applications according to the method of the present invention have superior electrical properties when compared to the silane-based nitride films.

Table 2.

| Electrical Properties of the Oxide/nitride Stack Films | | | | | | | | |
|---|---|---|---|---|---|---|---|---|
| # 01 | Bottom Oxide Dry Oxide 11A | CVD Nitride Silane 20A | NH3 anneal 0 | N2O anneal 30 | CET (A) @Vg=2V 34.764 | EOT (A) 29.203 | Jg(A/cm2) @Vg=1.5V 2.33E-05 | Vfb (V) -0.938 |
| 03 | dry Oxide 11A | silane 20A | 20 | 30 | 36.074 | 30.331 | 8.72E-06 | -0.931 |

Table 2. (continued)

| Electrical Properties of the Oxide/nitride Stack Films | | | | | | | | |
|---|---|---|---|---|---|---|---|---|
| # 01 | Bottom Oxide Dry Oxide 11A | CVD Nitride Silane 20A | NH3 anneal 0 | N2O anneal 30 | CET (A) @Vg=2V 34.764 | EOT (A) 29.203 | Jg(A/cm2) @Vg=1.5V 2.33E-05 | Vfb (V) -0.938 |
| 09 | NO Oxide 15A | silane 20A | 0 | 30 | 32.952 | 27.456 | 2.77E-04 | -0.918 |
| 11 | NO Oxide 15A | silane 20A | 20 | 30 | 35.268 | 29.637 | 2.37E-05 | -0.917 |
| 15 | NO Oxide 17A | silane 20A | 0 | 30 | 35.566 | 29.843 | 2.92E-05 | -0.917 |
| 17 | dry Oxide 15A | DCS 20A | 20 | 30 | 31.967 | 26.648 | 6.67E-06 | -0.897 |
| 19 | dry Oxide 15A | DCS 20A | 20 | 30 | 34.217 | 28.745 | 9.11E-07 | -0.886 |
| 23 | dry Oxide 15A | DCS 20A | 20 | 30 | 34.157 | 28.678 | 1.05E-06 | -0.879 |
| 25 | NO Oxide 15A | DCS 20A | 0 | 30 | 36.134 | 30.544 | 3.07E-07 | -0.868 |
| 27 | NO Oxide 15A | DCS 20A | 20 | 30 | 36.838 | 31.208 | 1.91E-07 | -0.865 |
| 31 | NO Oxide 17A | DCS 20A | 20 | 30 | 36.793 | 31.143 | 1.18E-07 | -0.881 |

The following Table 3 summarizes another set of experiments using the method of the present invention for depositing multilayer films on a substrate. Nitride films with thickness of 20Å were grown from DCS and $SiH_4$ on silicon substrates.

Table 3.

| Electrical Properties of the Oxide/nitride Stack and Nitride Films | | | | | | | | | |
|---|---|---|---|---|---|---|---|---|---|
| # | HF etch | Oxide | Nitride | $NH_3$ anneal | $N_2O$ anneal | CET (A) @Vg=-2.5V | EOT (A) | Jg (A/cm2) @Vg=-1.5V | Vfb (V) |
| 1 | HF | 24A dry ox at 850C | no | no | no | 29.691 | 25.633 | 0 | -0.873 |
| 2 | no HF | 24A dry ox at 850C | no | no | no | 29.936 | 25.776 | 0 | -0.906 |
| 3 | no HF | 24A dry ox at 850C | no | no | no | 31.069 | 26.955 | 0 | -0.84 |
| 4 | HF | 24A dry ox at 850C | no | no | no | 31.213 | 27.073 | 0 | -0.877 |

Table 3. (continued)

| Electrical Properties of the Oxide/nitride Stack and Nitride Films | | | | | | | | | |
|---|---|---|---|---|---|---|---|---|---|
| # | HF etch | Oxide | Nitride | $NH_3$ anneal | $N_2O$ anneal | CET (A) @Vg=-2.5V | EOT (A) | Jg (A/cm2) @Vg=-1.5V | Vfb (V) |
| 5 | HF | 16A dry ox at 850C | 20A SiH4 nitride | no | no | 28.811 | 24.663 | 0.00189 | -0.949 |
| 6 | HF | 16A dry ox at 850C | 20A SiH4 nitride | NH3 20sec 900C | N2O 20sec 900C | 31.068 | 26.865 | 0 | -0.913 |
| 7 | HF | 16A dry ox at 850C | 20A SiH2Cl2 nitride | no | no | 25.833 | 21.902 | 0.00372 | -0.913 |
| 8 | HF | 16A dry ox at 850C | 20A SiH2Cl2 nitride | NH3 20sec 900C | N2O 20sec 900C | 31.348 | 27.113 | 0 | -0.904 |
| 9 | HF | NO ox (800C 20sec) | 20A SiH4 nitride | no | no | | | 36.8 | |
| 10 | HF | NO ox (800C 20sec) | 20A SiH4 nitride | NH3 20sec 900c | N2O 20sec 900C | 30.275 | 26.092 | 0 | -0.942 |
| 11 | HF | NO ox (800C 20sec) | 20A SiH2Cl2 nitride | no | no | | | 9.58 | |
| 12 | HF | NO ox (800C 20sec) | 20A SiH2Cl2 nitride | NH3 20sec 900C | N2O 20sec 900C | 29.803 | 25.731 | 0 | -0.907 |
| 13 | HF | no | 20A SiH4 nitride | no | no | | | 8.12 | |
| 14 | HF | no | 20A SiH4 nitride | NH3 20sec 900C | N2O 20sec 900C | 28.369 | 24.115 | 0.00018 | -1.093 |
| 15 | HF | no | 20A SiH2Cl2 nitride | no | no | 27.3 | 22.874 | 0.0005 | -1.183 |
| 16 | HF | no | 20A SiH2Cl2 nitride | NH3 20sec 850C | N2O 20sec 850C | 29.739 | 25.458 | 0 | -1.048 |
| 17 | HF | no | 20A SiH4 nitride | NH3 20sec 850C | N2O 20sec 850C | 26.234 | 21.997 | 0.00074 | -1.159 |
| 18 | HF | no | 20A SiH2Cl2 nitride | NH3 20sec 900C | N2O 20sec 900C | 29.959 | 25.819 | 0.0001 | -0.962 |
| 19 | HF | 20A dry ox | no | no | no | 25.582 | 21.739 | 0.00299 | -0.879 |

Table 3. (continued)

| Electrical Properties of the Oxide/nitride Stack and Nitride Films | | | | | | | | | |
|---|---|---|---|---|---|---|---|---|---|
| # | HF etch | Oxide | Nitride | $NH_3$ anneal | $N_2O$ anneal | CET (A) @Vg=-2.5V | EOT (A) | Jg (A/cm2) @Vg=-1.5V | Vfb (V) |
| 20 | HF | 20A dry ox | no | no | no | 25.681 | 21.864 | 0.00266 | -0.859 |

FIGs. 9A and 9B are graphs illustrating C-V and I-V curves respectively for a film deposited on wafer No. 15 in Table 3 according to one embodiment of the present invention. An EOT of 22Å was derived from the C-V measurement (FIG. 9A) of the 20Å DCS-based nitride (wafer No. 15). The current density of this film was 5.02 x $10^{-4}$ A/$cm^2$ at -1.5V (FIG. 10B). FIGs. 10A and 10B are graphs illustrating C-V and I-V curves respectively for a film deposited on wafer No. 13 in Table 3 using prior art methods. For the 20Å silane-based nitride (wafer No.13), no capacitance accumulation was observed (FIG. 10A) and the current density was 8.12 A/$cm^2$ at -1.5V (FIG. 10B). The comparison of the electrical properties of the films on wafer No. 15 and 13 in Table 3 and FIGs 9A-9B and FIGs 10A-10B clearly reveal that the DCS-based nitride films of the present invention exhibited better electrical properties than the silane-based nitride film. The superior electrical properties of DCS-based nitride over silane-based nitride films may be attributed at least in part to the ease of stoichiometry control of $Si_3N_4$ and less hydrogen incorporation in the deposited films achieved by the system and method embodying the invention.

Table 4 summarizes another set of experiments using the method according to one embodiment of the present invention for depositing nitride and oxide films on p-type substrates. Nitride films and dry oxide films with thickness of 15Å were grown from DCS on 8" p-type prime wafers to form NMOS.

Table 4

| Process Conditions and Electrical Properties of Films for NMOS | | | | | | | | | |
|---|---|---|---|---|---|---|---|---|---|
| Slot# nmos | Films | | Anneal Temp. (C) | NH3 anneal (s) | N2O anneal (s) | Jg @ -1.5V (A/cm2) | EO T (A) | Vfb (V) | Na (#/cm3) |
| 1 | DCS nitride 15A | 0 | 850 | 20 | 20 | 9.47E-04 | 22.5 | -0.91 | 4.90E+15 |
| 2 | DCS nitride 15A | -++ | 800 | 30 | 30 | 3.21E-03 | 21.7 | -0.9 | 5.26E+15 |
| 3 | DCS nitride 15A | -+- | 800 | 30 | 10 | 9.14E-03 | 20.6 | -0.9 | 5.40E+15 |
| 4 | DCS nitride 15A | ++- | 900 | 30 | 10 | 2.25E-04 | 23.4 | -0.93 | 5.40E+15 |
| 5 | DCS nitride 15A | +-+ | 900 | 10 | 30 | 2.51E-04 | 23.6 | -0.89 | 5.58E+15 |
| 6 | DCS nitride 15A | +-- | 900 | 10 | 10 | 8.13E-04 | 22.9 | -0.9 | 6.05E+15 |
| 7 | DCS nitride 15A | +++ | 900 | 30 | 30 | 7.09E-05 | 25.1 | -0.89 | 2.58E+15 |
| 8 | DCS nitride 15A | --+ | 800 | 10 | 30 | 7.24E-03 | 20.8 | -0.89 | 4.70E+15 |

Table 4 (continued)

| Process Conditions and Electrical Properties of Films for NMOS | | | | | | | | | |
|---|---|---|---|---|---|---|---|---|---|
| Slot# nmos | Films | | Anneal Temp. (C) | NH3 anneal (s) | N2O anneal (s) | Jg @ -1.5V (A/cm2) | EO T (A) | Vfb (V) | Na (#/cm3) |
| 9 | DCS nitride 15A | --- | 800 | 10 | 10 | 2.84E-02 | 19.5 | -0.91 | 6.82E+15 |
| 10 | DCS nitride 15A | 0xx | 850 | 0 | 0 | 3.93E+01 | | | |
| 11 | DCS nitride 15A | | 900 | 20 | 20 | 2.00E-04 | 23.7 | -0.9 | 4.63E+15 |
| 12 | Dry Ox 15A | | | | | 2.18E+01 | 22.5 | -0.87 | 4.20E+15 |
| 13 | Dry Ox 15A | | | | | 2.99E-03 | | | |

FIGs 11A and 11B are graphs illustrating C-V and I-V curves respectively for a film deposited on wafer No. 9 in Table 4. FIG 12 is a graph illustrating the current density versus the EOT of the nitride or oxide films formed on wafer No. 1-13 in Table 4. Table 4 and FIGS. 11A-11B and FIG. 12 clearly demonstrate the superior electrical properties of the dielectric films deposited according to the method of the present invention.

Example 5

This example illustrates another set of multilayer dielectric films formed according to the method of the present invention and boron blocking effect of these films.

Table 5 summarizes the experiments according to one embodiment of the present inventive method for depositing nitride films and nitride/oxide films on n-type substrates. Nitride films and dry oxide films were grown from DCS and $SiH_4$ on 8" n-type prime wafers to form PMOS.

Table 5

| Process Conditions and Electrical Properties of Films for PMOS | | | | | | | | | | |
|---|---|---|---|---|---|---|---|---|---|---|
| # | Split | Wafer ID# | HF Etch | Bottom Oxide | Nitride | $NH_3$ Anneal | $N_2O$ Annea 1 | 900C 30sec N2 Anneal Vfb (V) | 950C 30sec N2 Anneal Vfb (V) | 1000C 30sec N2 Anneal Vfb (V) |
| 1 | 1 | NKF00287 A | HF last | N.O. oxide (800C, 10sec) | 20Å SiH4 nitride | $NH_3$, 20sec, 900°C | $N_2O$, 20sec, 900°C | 0.79 | 0.79 | 3 |
| 2 | 2 | NKF00258 A | HF last | no | 20Å SiH4 nitride | $NH_3$, 20sec, 900°C | $N_2O$, 20sec, 900°C | 0.74 | 0.76 | 1.17 |
| 3 | 3 | NKF00064 A | HF last | no | 15Å SiH4 nitride | $NH_3$, 20sec, 900°C | $N_2O$, 20sec, 900°C | 0.73 | 0.74 | 1.75 |

Table 5 (continued)

| Process Conditions and Electrical Properties of Films for PMOS | | | | | | | | | | |
|---|---|---|---|---|---|---|---|---|---|---|
| # | Split | Wafer ID# | HF Etch | Bottom Oxide | Nitride | $NH_3$ Anneal | $N_2O$ Anneal | 900C 30sec N2 Anneal Vfb (V) | 950C 30sec N2 Anneal Vfb (V) | 1000C 30sec N2 Anneal Vfb (V) |
| 4 | 4 | NKF00563 A | HF last | N.O. oxide (800C, 10sec) | 20Å $SiH_2Ci_2$ nitride | $NH_3$, 20sec, 900°C | $N_2O$, 20sec, 900°C | 0.73 | 0.74 | 0.95 |
| 5 | 5 | NKF00488 A | HF last | no | 20Å $SiH_2Cl_2$ nitride | $NH_3$, 20sec, 900°C | $N_2O$, 20sec, 900°C | 0.69 | 0.66 | 0.67 |
| 6 | 6 | NKF00404 A | HF last | no | 15Å $SiH_2Cl_2$ nitride | $NH_3$, 20sec, 900°C | $N_2O$, 20sec, 900°C | 0.74 | 0.78 | 1.77 |

FIG 13 is a graph illustrating Vfb versus anneal temperature curve for the films deposited on wafers No.1-6 in Table 5 according to one embodiment of the present invention. FIGs. 14-19 are graphs illustrating V-C curves for the films deposited on wafers No.1-6 respectively in Table 5. FIGs 14-19 and Table 5 clearly demonstrate the superior electrical properties of the films deposited according to the present invention.

The foregoing description of specific embodiments and examples of the invention have been presented for the purpose of illustration and description, and although the invention has been illustrated by certain of the preceding examples, it is not to be construed as being limited thereby. They are not intended to be exhaustive or to limit the invention to the precise forms disclosed, and obviously many modifications, embodiments, and variations are possible in light of the above teaching. It is intended that the scope of the invention encompass the generic area as herein disclosed, and by the claims appended hereto and their equivalents.

## Claims

**1.** A method of depositing a dielectric film on the surface of a substrate, comprising:

providing a substrate in a hot-wall thermal processing chamber; and
reacting a chlorine containing silicon precursor with ammonia and/or an oxygen containing precursor to form a dielectric film on the surface of the substrate.

**2.** The method according to claim 1 wherein the processing chamber is maintained at a pressure from about 0.01 to 10 Torr, and the chlorine containing silicon precursor is reacted with ammonia at a ratio of chlorine containing silicon precursor to ammonia from about 1:3 to about 1:10.at a temperature from about 550 to about 900°C to form a silicon nitride film on the substrate.

**3.** The method according to claim 2 wherein the processing chamber is maintained at a pressure from about 0.1 to about 5 Torr, and the chlorine containing silicon precursor is reacted with ammonia at a temperature in a range from about 600°C to 800°C.

**4.** The method according to any of claims 1 to 3 wherein the chlorine containing silicon precursor is selected from the group consisting of $SiH_2Cl_2$, $SiH_3Cl$, $SiHCl_3$, $SiCl_4$, and $Si_2Cl_6$.

**5.** The method according to claim 1 wherein the processing chamber is maintained at a pressure from about 0.01 Torr to about 10 Torr, and the silicon precursor is reacted with an oxygen containing precursor at a ratio of the silicon precursor to the oxygen containing precursor from about 1:3 to about 1:10 at a temperature from about 550°C to about 1000°C to form a silicon oxide film on the substrate.

**6.** The method according to claim 5 wherein the processing chamber is maintained at a pressure from about 0.1 to about 5 Torr and the silicon precursor is reacted with the oxygen containing precursor at a temperature from about 700°C to about 900°C.

**7.** The method according to claim 5 or 6 wherein the silicon precursor is selected from the group consisting of $SiH_2Cl_2$, $SiH_3Cl$, $SiClH_3$, $SiCl_4$, $Si_2Cl_6$, $SiH_4$, $Si(OC_2H_5)_4$, and aminosilane, and the oxygen containing precursor is selected from the group consisting of $N_2O$, NO, $O_2$, and any combination thereof.

**8.** The method according to claim 1 wherein the process chamber is maintained at a pressure from about 0.01 Torr to 10 Torr, and the silicon precursor is reacted with ammonia and $N_2O$ at a ratio of silicon precursor to $NH_3$ and $N_2O$ from about 1:3 to about 1:10 at a temperature from about 550°C to about 1000°C to form an oxynitride film on the substrate.

**9.** The method according to claim 8 wherein the processing chamber is maintained at a pressure from about 0.1 to about 5 Torr, and the silicon precursor is reacted with ammonia and $N_2O$ at a temperature from about 600 to about 900°C.

**10.** The method according to claim 8 or 9 wherein the silicon precursor is selected from the group consisting of $SiH_2Cl_2$, $SiH_3Cl$, $SiClH_3$, $SiCl_4$, $Si_2Cl_6$, $SiH_4$, $Si(OC_2H_5)_4$, and aminosilane.

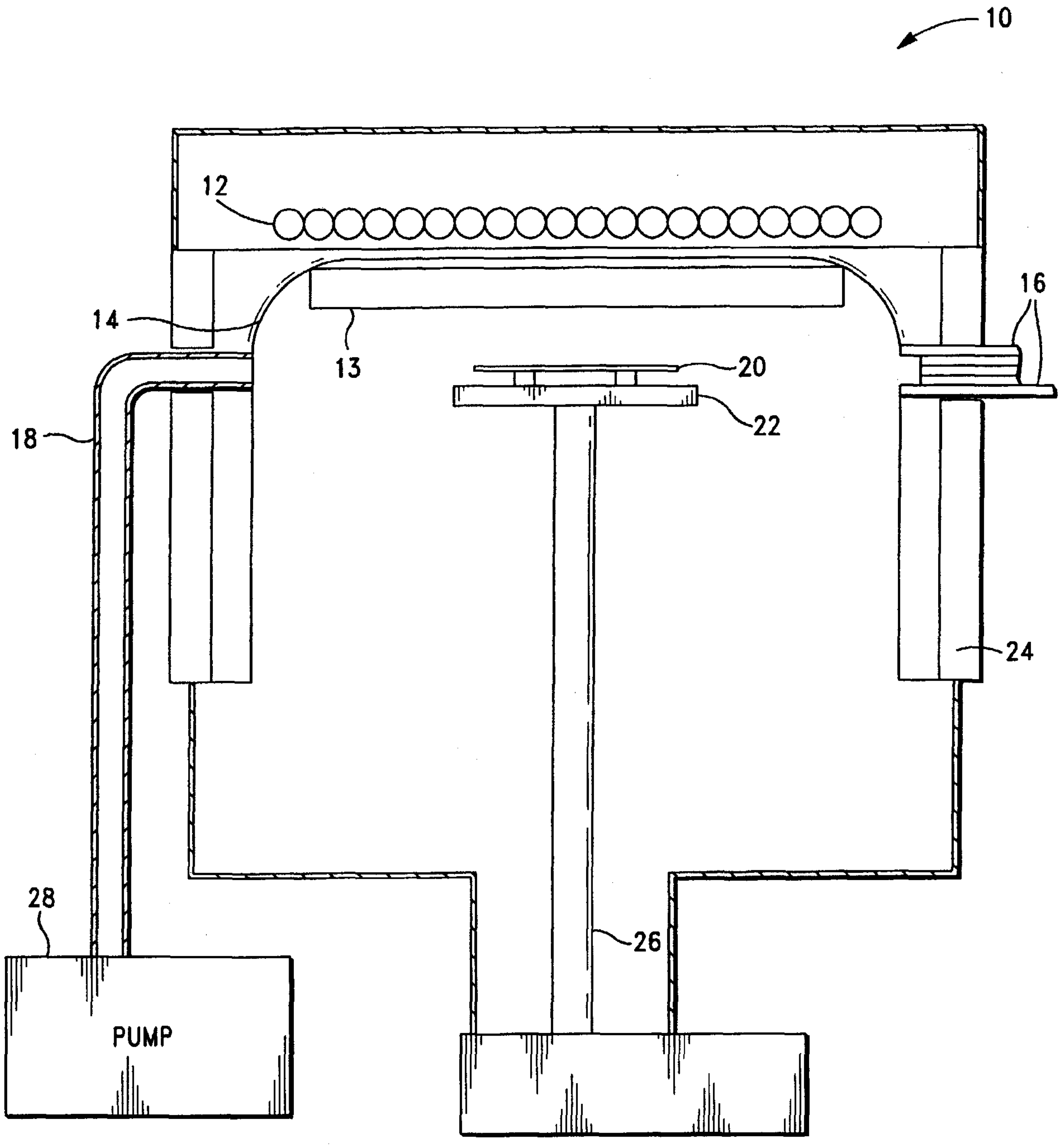


FIG.1

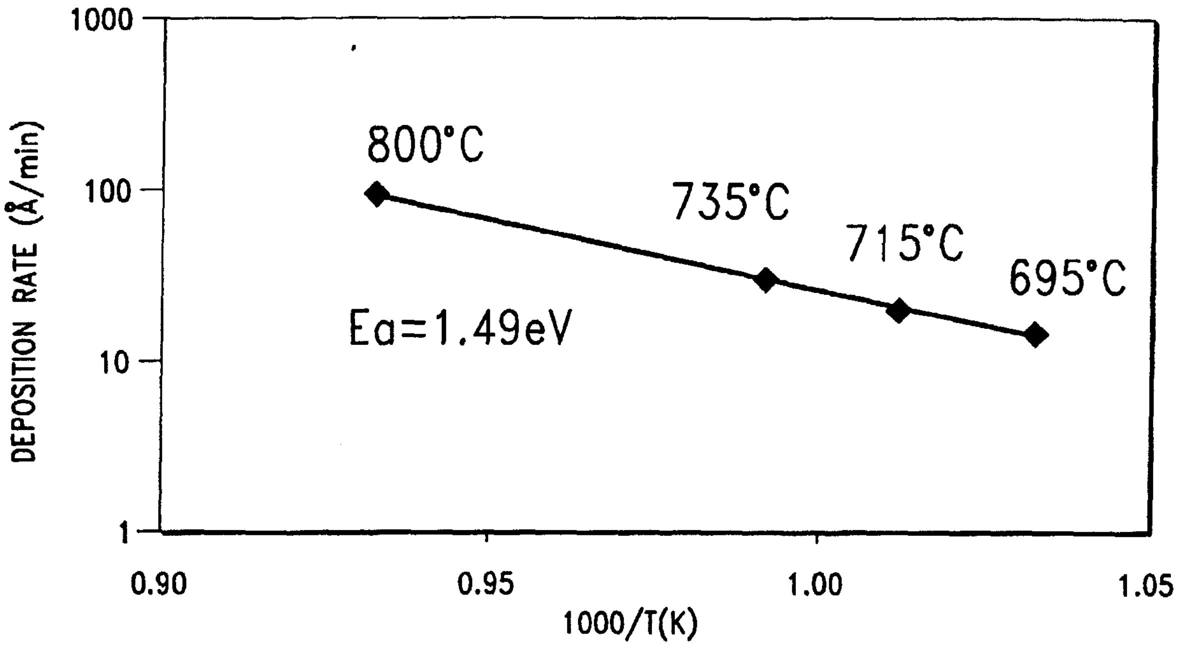
1000
100
10
1
DEPOSITION RATE (Å/min)
800°C
735°C
715°C
695°C
Ea=1.49eV
0.90
0.95
1.00
1.05
1000/T(K)

*FIG.2*

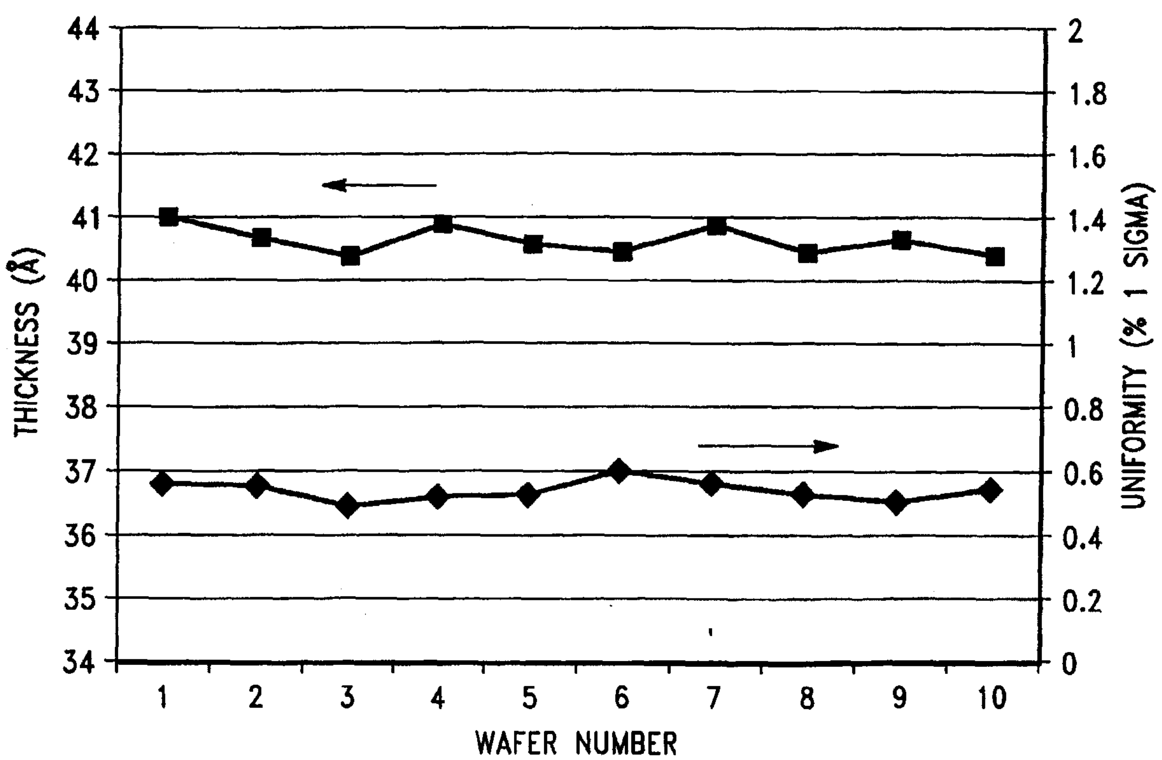
44
43
42
41
40
39
38
37
36
35
34
THICKNESS (Å)
2
1.8
1.6
1.4
1.2
1
0.8
0.6
0.4
0.2
0
UNIFORMITY (% 1 SIGMA)
1
2
3
4
5
6
7
8
9
10
WAFER NUMBER

*FIG.3*

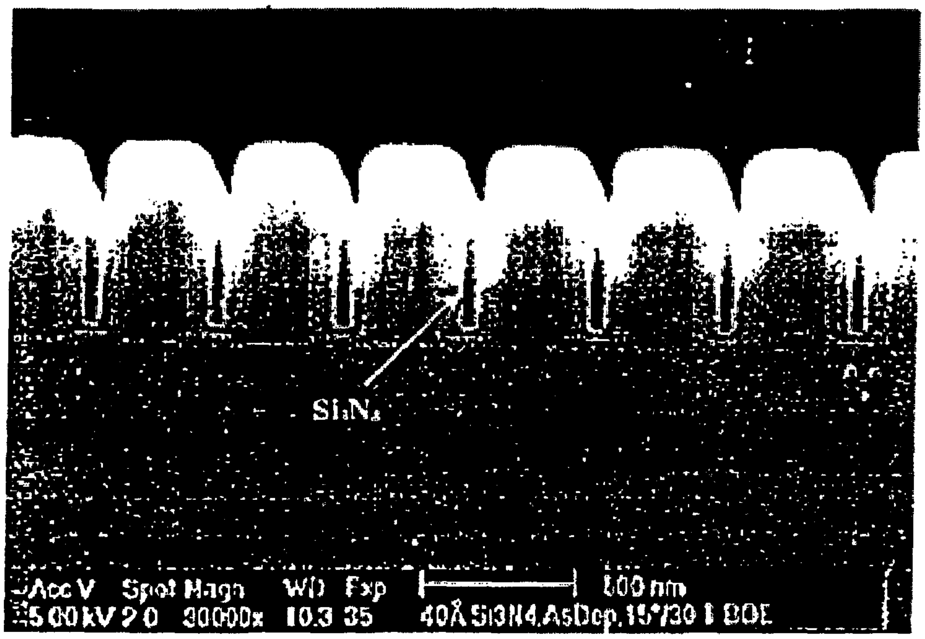
Si3N4
Acc V Spot Magn WD Exp
5.00 kV 2.0 30000x 10.3 35
100 nm
40Å Si3N4,AsDep,15*/30 I DOE

*FIG. 4*

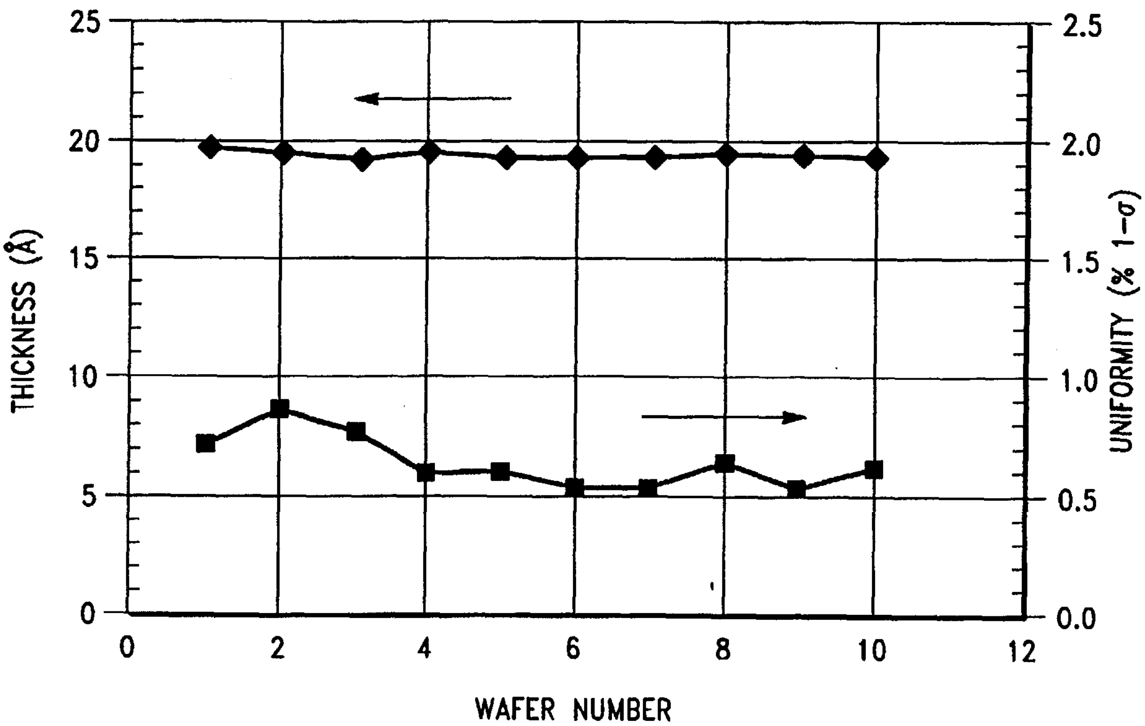
25
20
15
10
5
0
THICKNESS (Å)
2.5
2.0
1.5
1.0
0.5
0.0
UNIFORMITY (% 1-σ)
0
2
4
6
8
10
12
WAFER NUMBER

*FIG. 5*

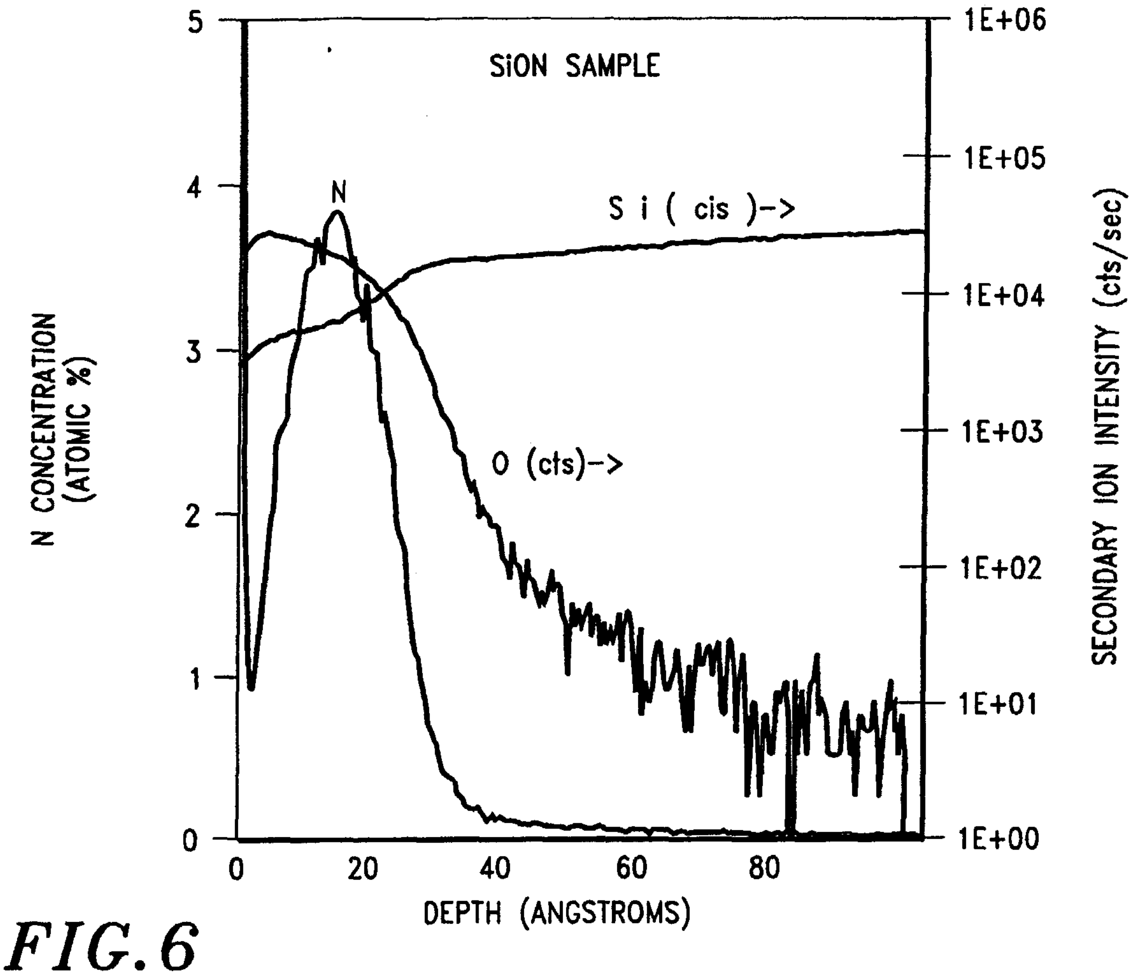
SiON SAMPLE
N
S i ( cis )->
O (cts)->
N CONCENTRATION (ATOMIC %)
SECONDARY ION INTENSITY (cts/sec)
DEPTH (ANGSTROMS)
5
4
3
2
1
0
1E+06
1E+05
1E+04
1E+03
1E+02
1E+01
1E+00
0
20
40
60
80

*FIG.6*

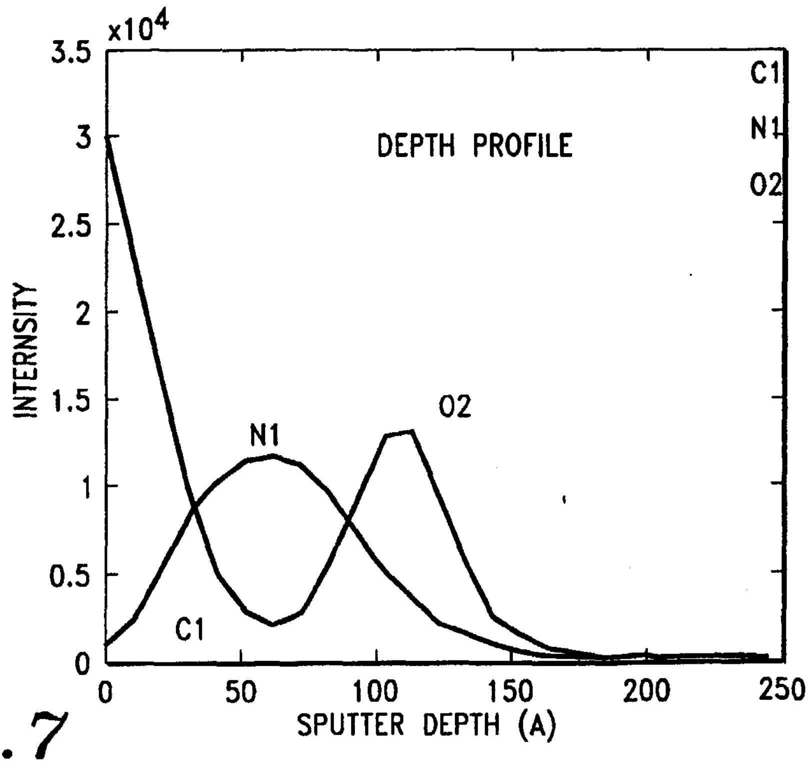
x10^4
DEPTH PROFILE
C1
N1
O2
N1
O2
C1
INTERNSITY
SPUTTER DEPTH (A)
3.5
3
2.5
2
1.5
1
0.5
0
0
50
100
150
200
250

*FIG.7*

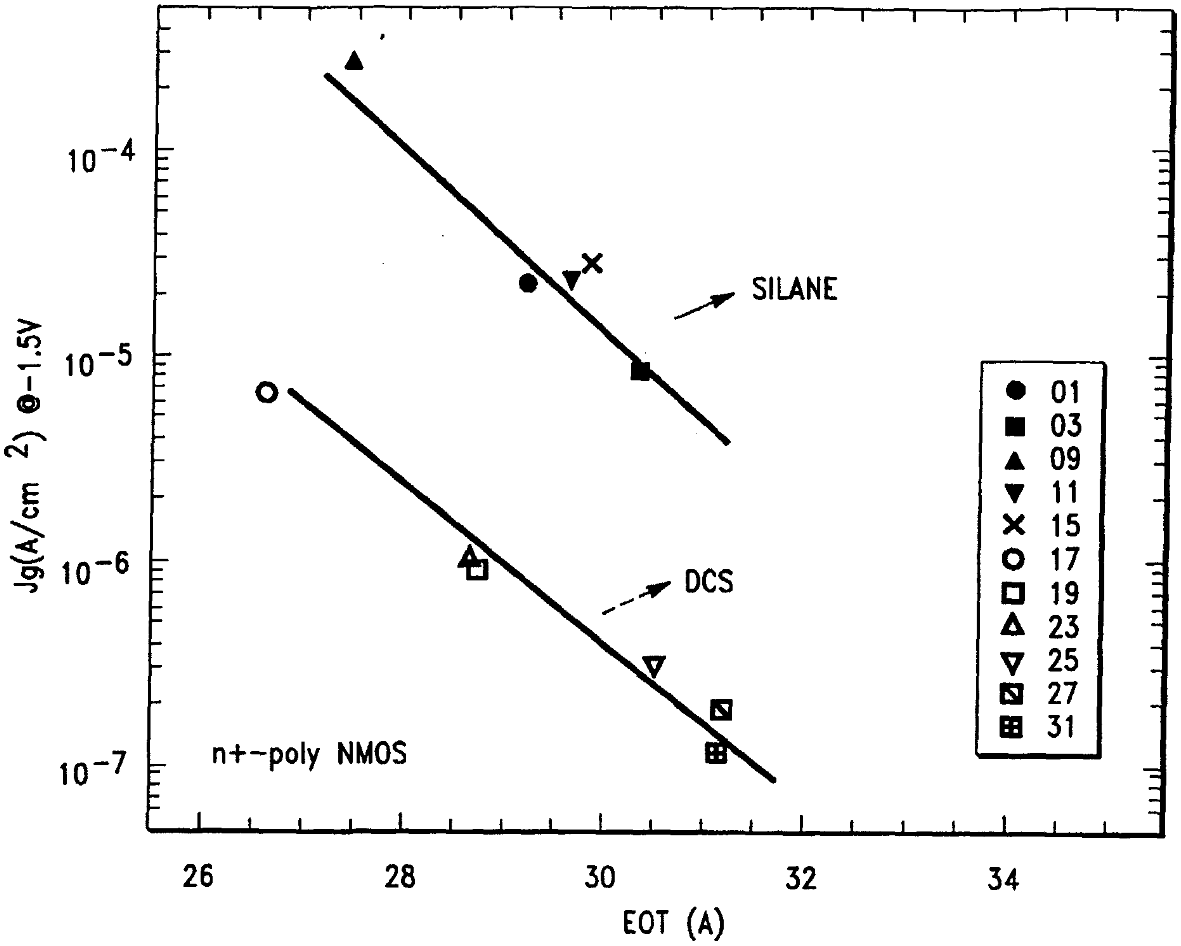

10^-4
10^-5
10^-6
10^-7
Jg(A/cm 2) @-1.5V
SILANE
DCS
n+-poly NMOS
01
03
09
11
15
17
19
23
25
27
31
26
28
30
32
34
EOT (A)


*FIG.8*

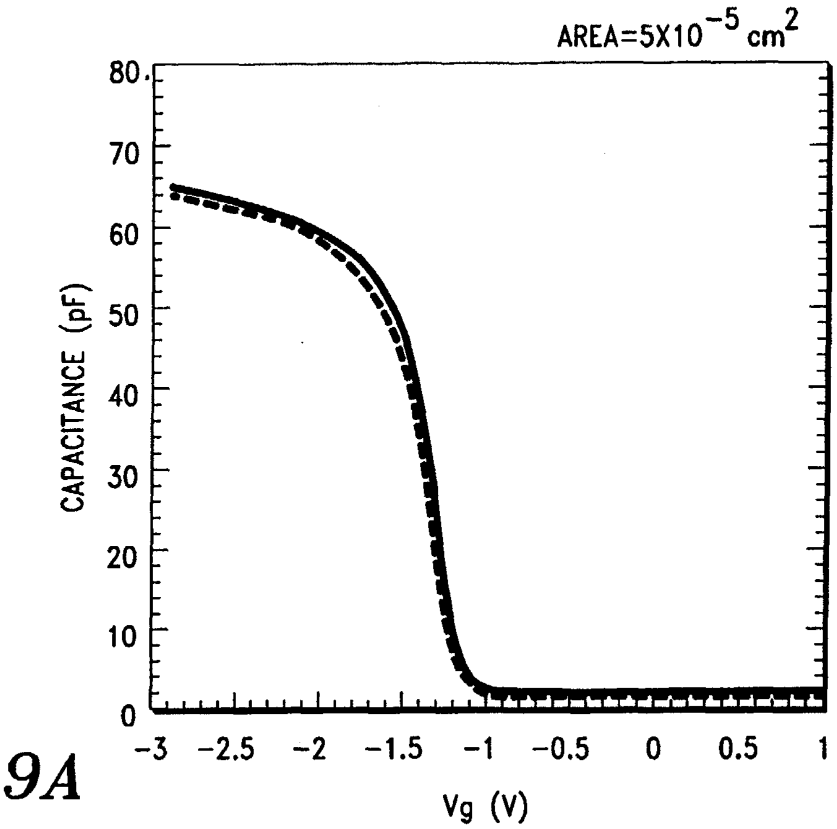
AREA=5X10$^{-5}$ cm$^2$
CAPACITANCE (pF)
80
70
60
50
40
30
20
10
0
−3
−2.5
−2
−1.5
−1
−0.5
0
0.5
1
Vg (V)

*FIG. 9A*

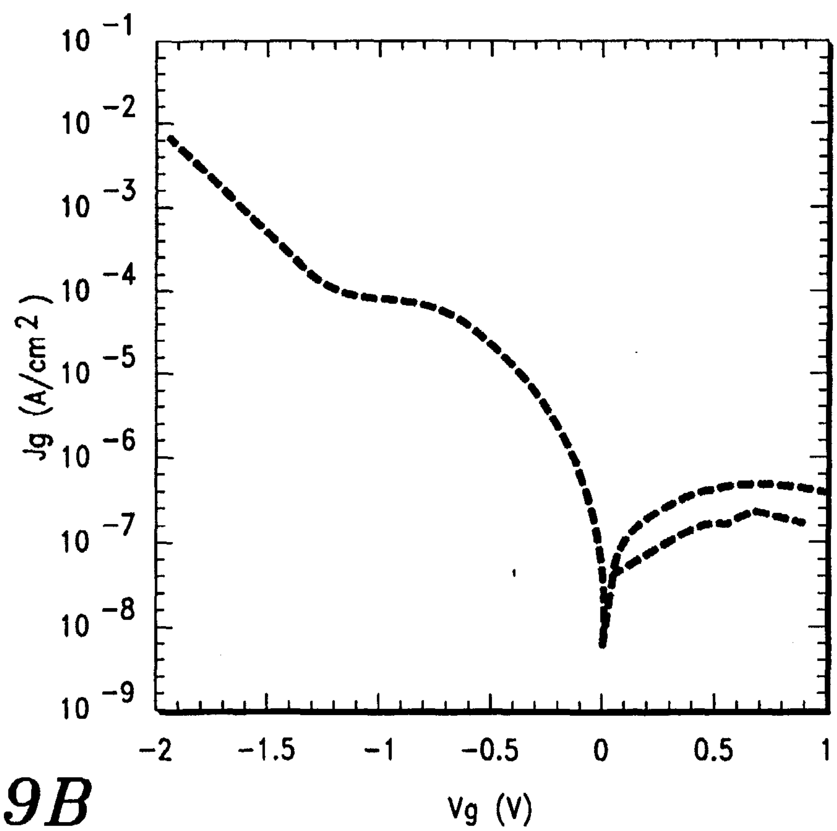
Jg (A/cm$^2$)
$10^{-1}$
$10^{-2}$
$10^{-3}$
$10^{-4}$
$10^{-5}$
$10^{-6}$
$10^{-7}$
$10^{-8}$
$10^{-9}$
−2
−1.5
−1
−0.5
0
0.5
1
Vg (V)

*FIG. 9B*

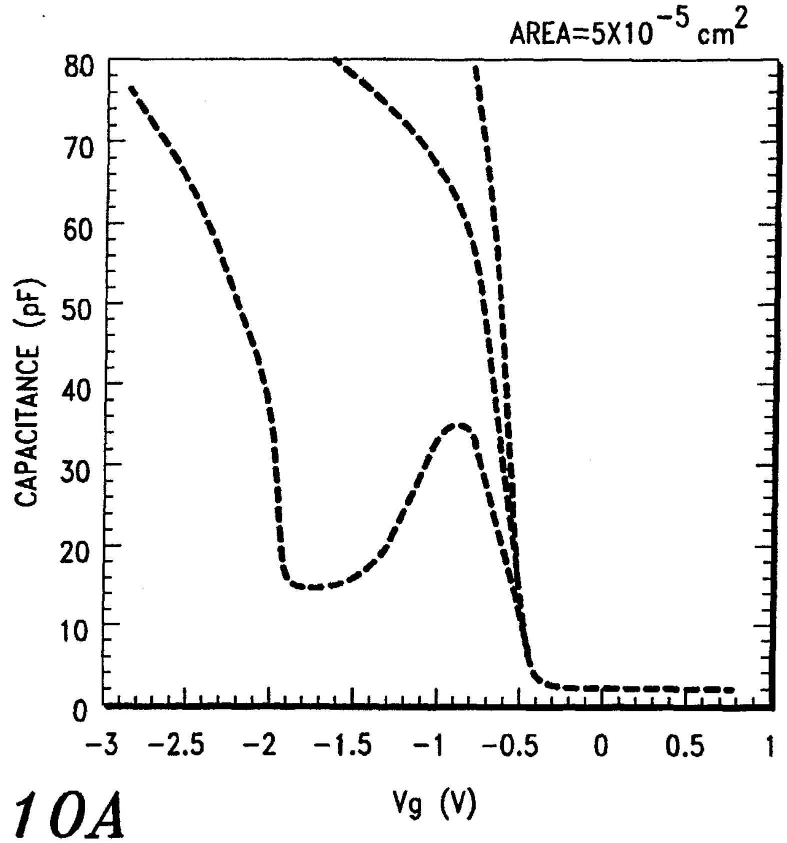


FIG. 10A

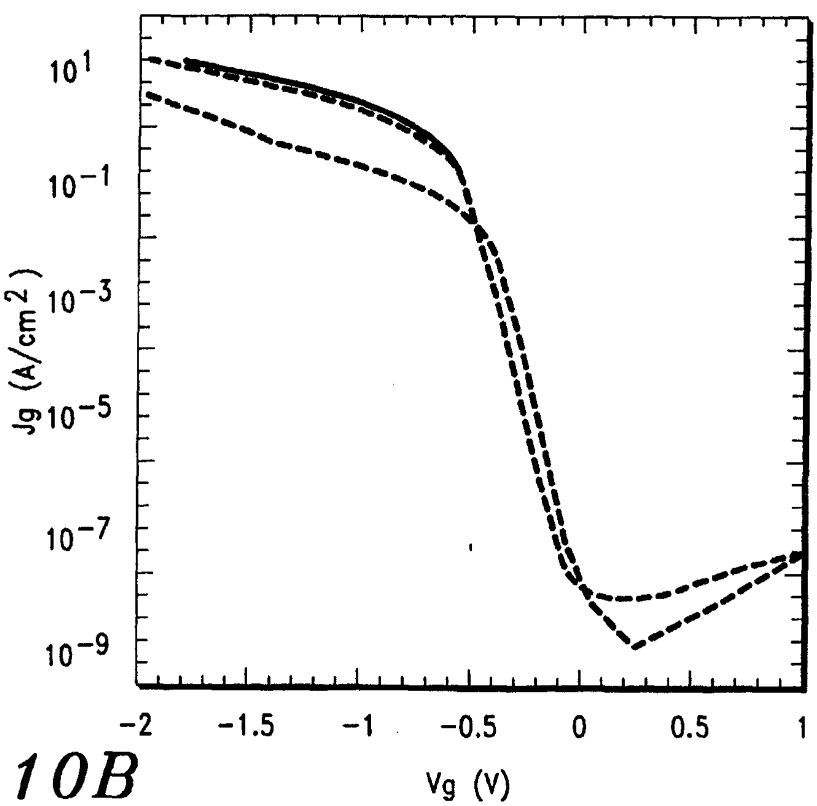


FIG. 10B

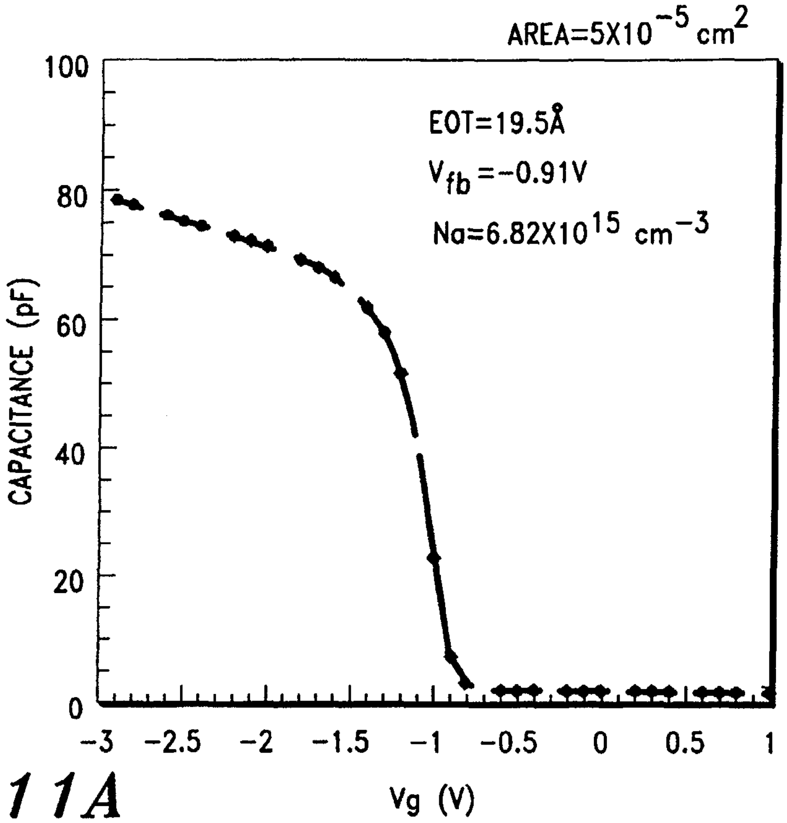


*FIG. 11A*

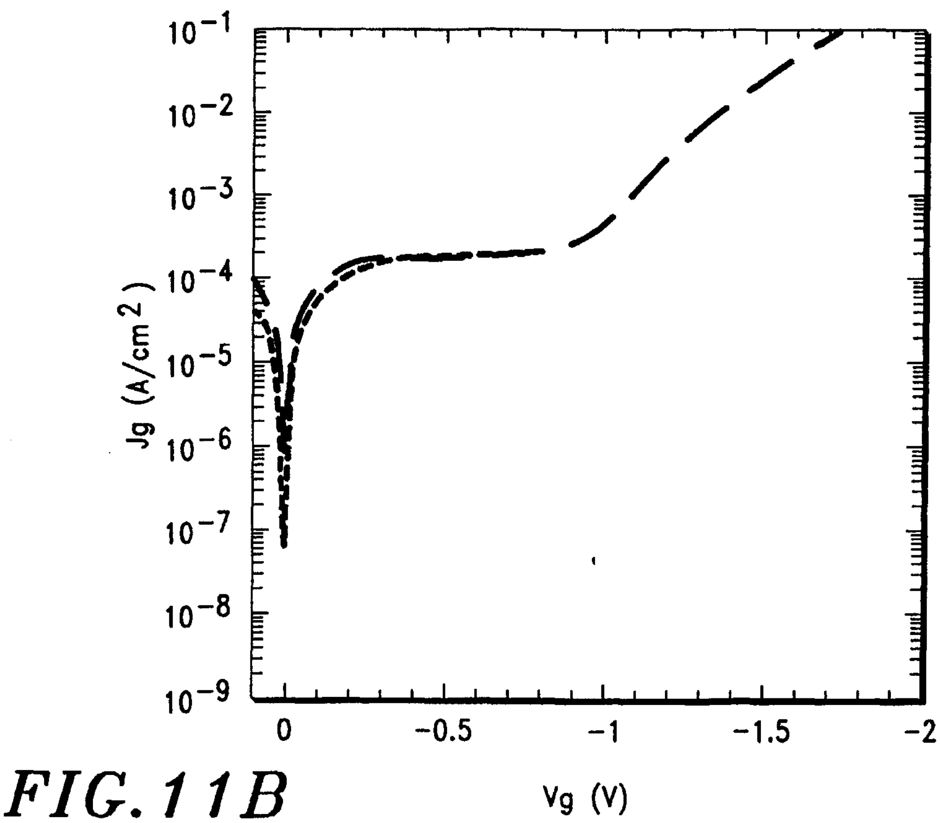


*FIG. 11B*

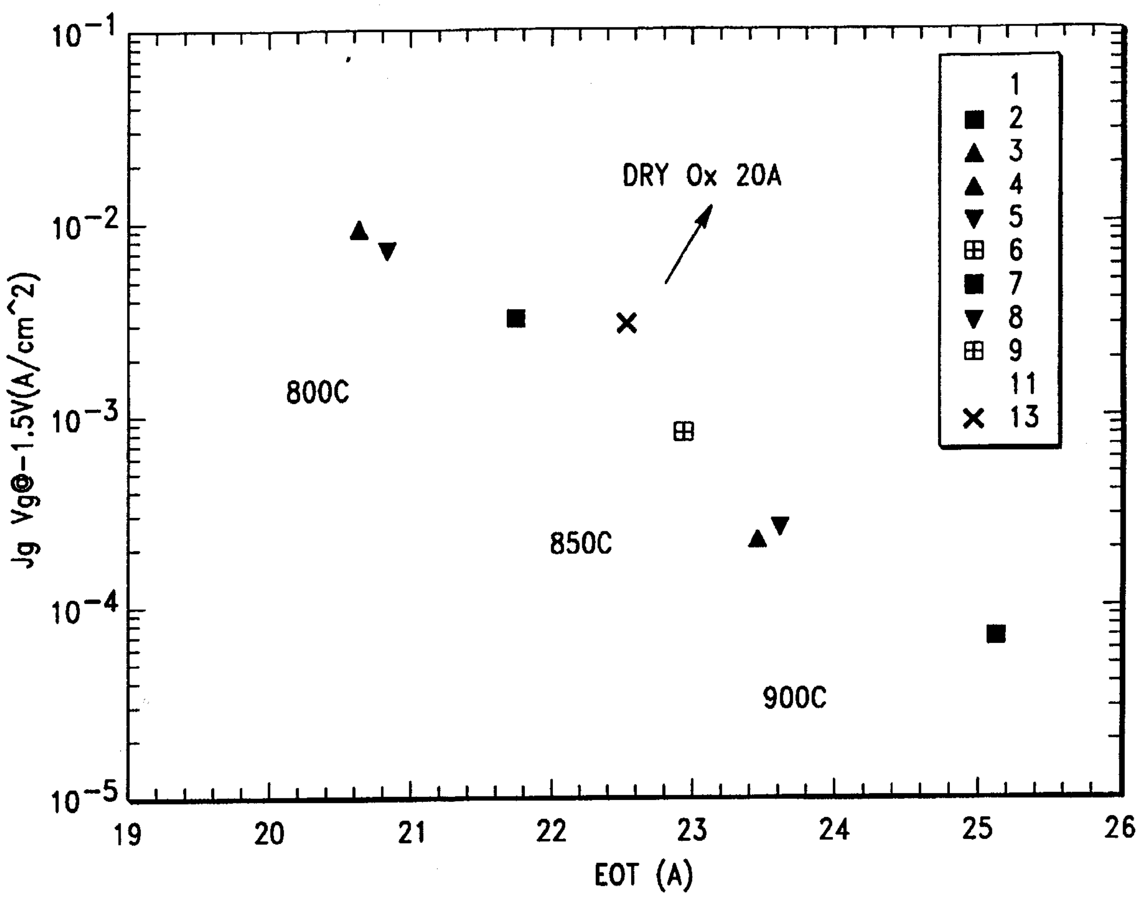

$10^{-1}$
$10^{-2}$
$10^{-3}$
$10^{-4}$
$10^{-5}$
Jg Vg@-1.5V(A/cm^2)
19
20
21
22
23
24
25
26
EOT (A)
DRY Ox 20A
800C
850C
900C
1
2
3
4
5
6
7
8
9
11
13


*FIG. 12*

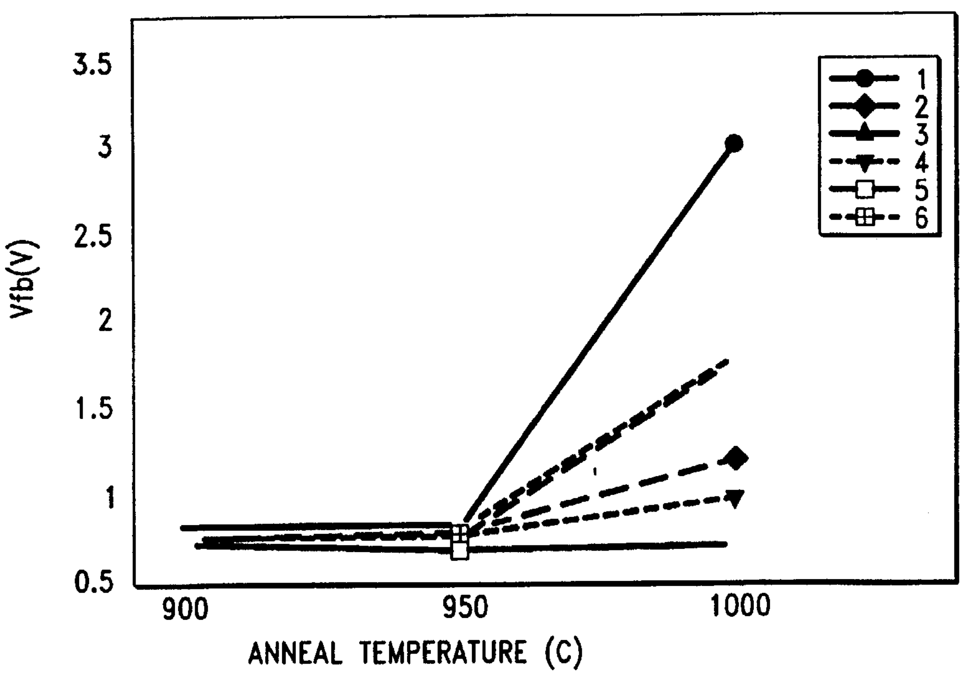

3.5
3
2.5
2
1.5
1
0.5
Vfb(V)
900
950
1000
ANNEAL TEMPERATURE (C)
1
2
3
4
5
6


*FIG. 13*

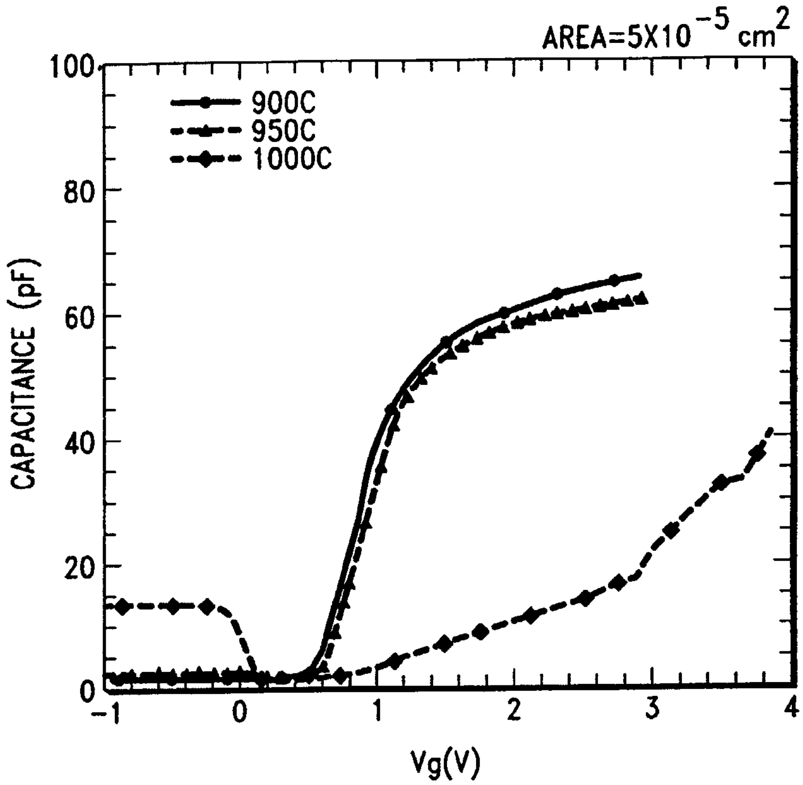
AREA=5X10$^{-5}$ cm$^{2}$
900C
950C
1000C
CAPACITANCE (pF)
100
80
60
40
20
0
-1
0
1
2
3
4
Vg(V)

FIG. 14

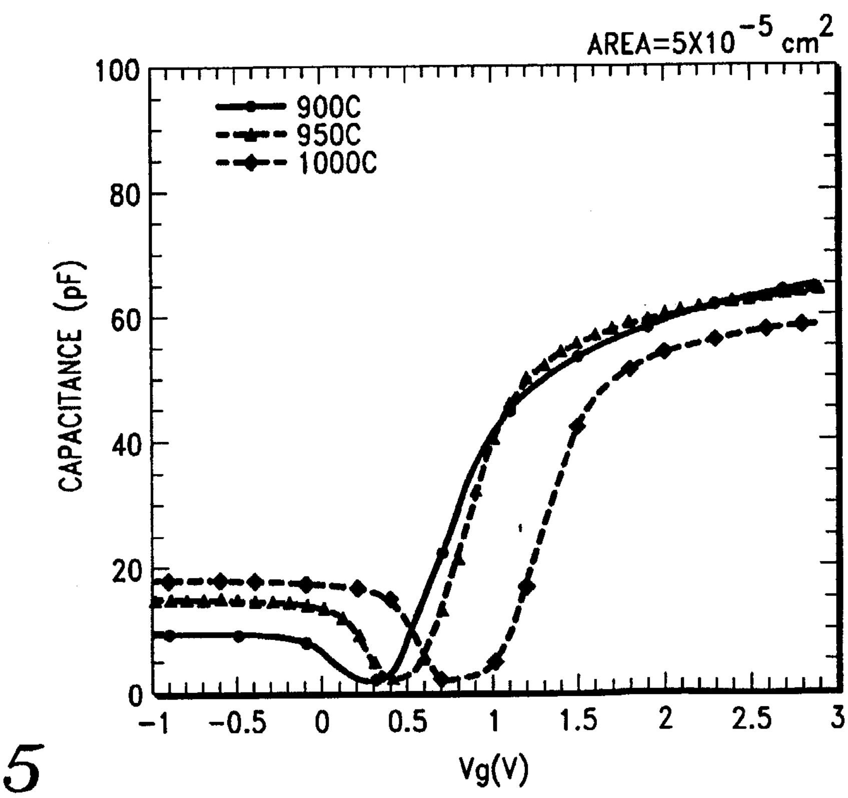
AREA=5X10$^{-5}$ cm$^{2}$
900C
950C
1000C
CAPACITANCE (pF)
100
80
60
40
20
0
-1
-0.5
0
0.5
1
1.5
2
2.5
3
Vg(V)

FIG. 15

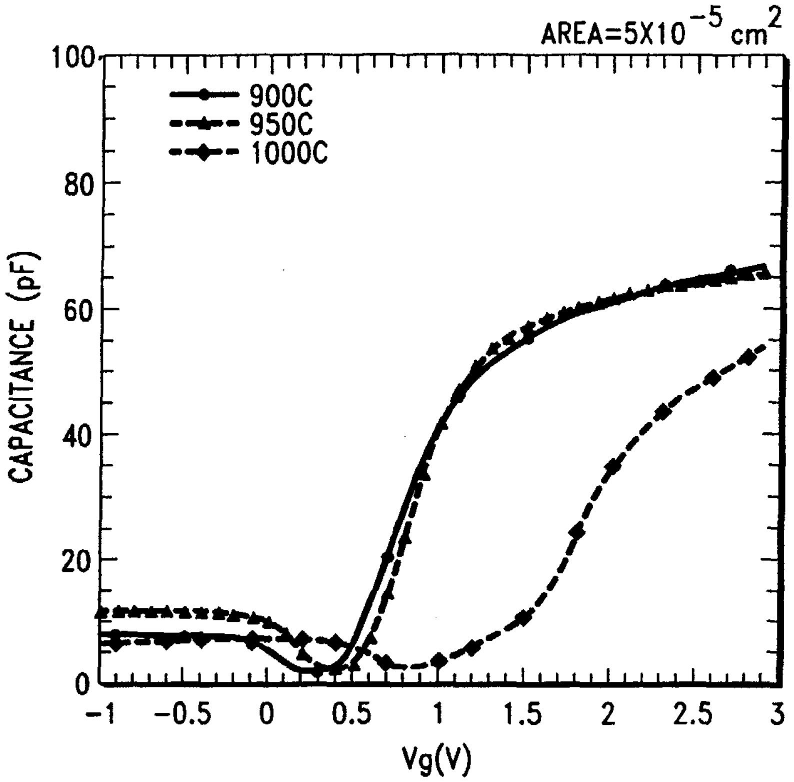
AREA=5X10$^{-5}$ cm$^2$
900C
950C
1000C
CAPACITANCE (pF)
Vg(V)
100
80
60
40
20
0
-1
-0.5
0
0.5
1
1.5
2
2.5
3

FIG. 16

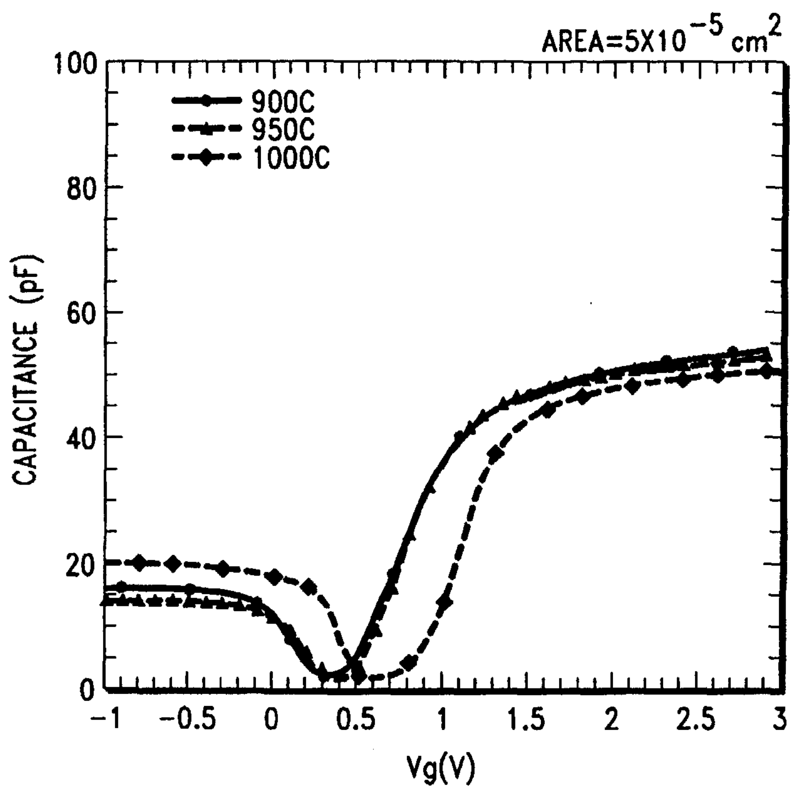
AREA=5X10$^{-5}$ cm$^2$
900C
950C
1000C
CAPACITANCE (pF)
Vg(V)
100
80
60
40
20
0
-1
-0.5
0
0.5
1
1.5
2
2.5
3

FIG. 17

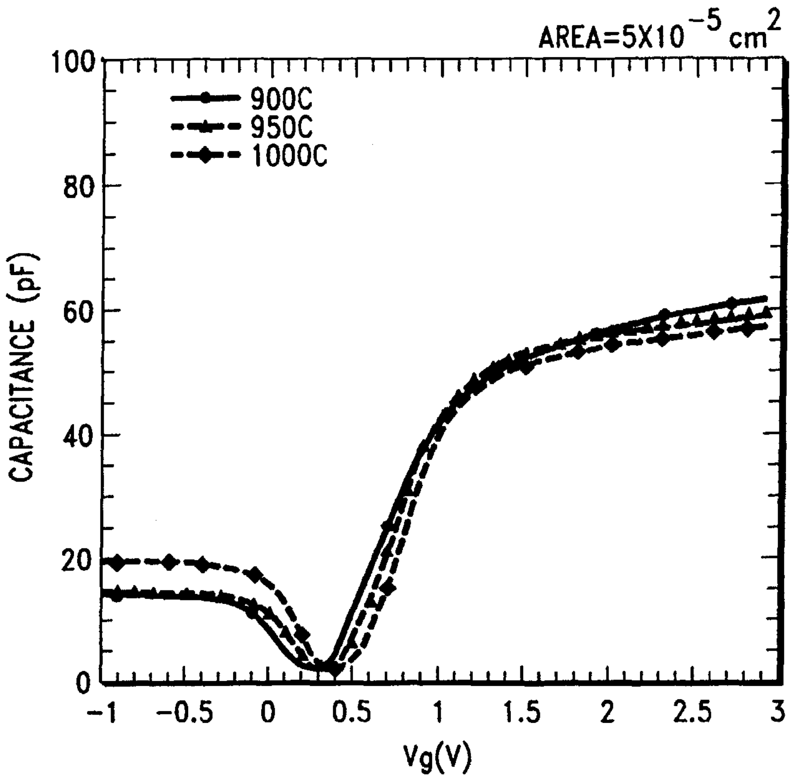
AREA=5X10$^{-5}$ cm$^2$
900C
950C
1000C
CAPACITANCE (pF)
100
80
60
40
20
0
−1
−0.5
0
0.5
1
1.5
2
2.5
3
Vg(V)

*FIG. 18*

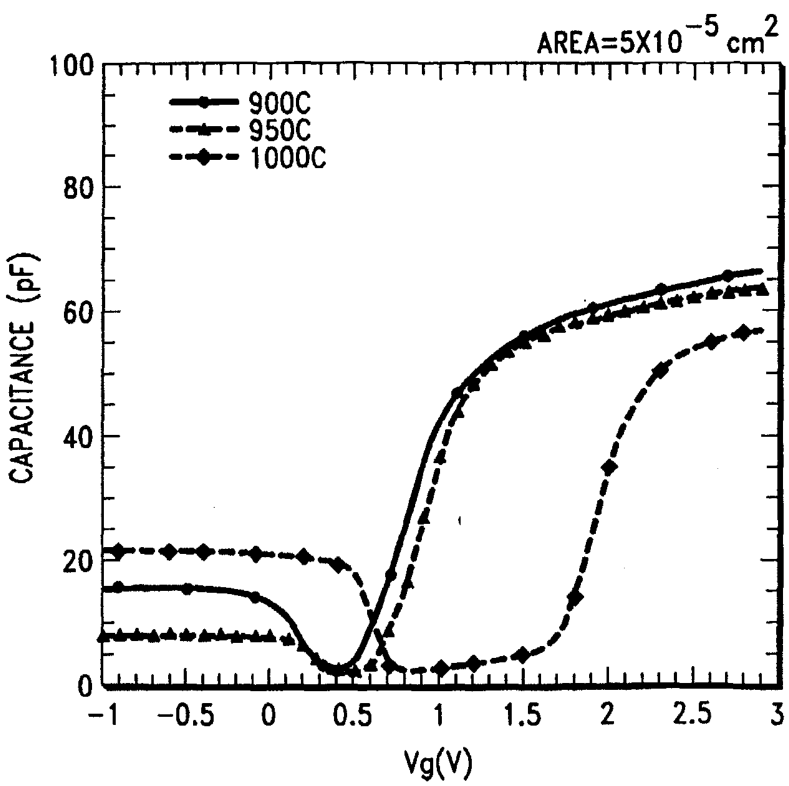
AREA=5X10$^{-5}$ cm$^2$
900C
950C
1000C
CAPACITANCE (pF)
100
80
60
40
20
0
−1
−0.5
0
0.5
1
1.5
2
2.5
3
Vg(V)

*FIG. 19*

European Patent Office

# EUROPEAN SEARCH REPORT

Application Number
EP 02 25 7838

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 047 117 A (OKI ELECTRIC IND CO LTD) 25 October 2000 (2000-10-25) * paragraphs '0015!,'0022! * --- | 1-4 | C23C16/40 C23C16/34 C23C16/30 |
| X | US 4 239 811 A (KEMLAGE BERNARD M) 16 December 1980 (1980-12-16) * column 3, line 27 - line 46 * --- | 1,5-7 | |
| X | EP 0 260 473 A (IBM) 23 March 1988 (1988-03-23) * column 5, line 27 - line 43 * --- | 1,8-10 | |
| X | SENZAKI Y ET AL: "Single-wafer furnace RTCVD for silicon oxide, nitride, and oxynitride thin films" 9TH INTERNATIONAL CONFERENCE ON ADVANCED THERMAL PROCESSING OF SEMICONDUCTORS. RTP 2001 (CAT. NO.02EX513), 9TH INTERNATIONAL CONFERENCE ON ADVANCED THERMAL PROCESSING OF SEMICONDUCTORS. RTP 2001, ANCHORAGE, AK, USA, 25-29 SEPT. 2001, pages 197-200, XP001149309 2001, Scottsdale, AZ, USA, RTP, USA * the whole document * ----- | 1-4 | TECHNICAL FIELDS SEARCHED (Int.Cl.7) C23C |

The present search report has been drawn up for all claims

| Place of search | Date of completion of the search | Examiner |
|---|---|---|
| THE HAGUE | 10 March 2003 | Ekhult, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent Office

Application Number

EP 02 25 7838

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☒ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

European Patent Office

# LACK OF UNITY OF INVENTION SHEET B

Application Number
EP 02 25 7838

The Search Division considers that the present European patent application does not comply with the requirements of unity of invention and relates to several inventions or groups of inventions, namely:

1. Claims: 1-4

   CVD deposition of silicon nitride.

2. Claims: 1,5-7

   CVD deposition of silicon oxide.

3. Claims: 1,8-10

   CVD deposition of silicon oxynitride.

## ANNEX TO THE EUROPEAN SEARCH REPORT ON EUROPEAN PATENT APPLICATION NO. EP 02 25 7838

This annex lists the patent family members relating to the patent documents cited in the above-mentioned European search report.
The members are as contained in the European Patent Office EDP file on
The European Patent Office is in no way liable for these particulars which are merely given for the purpose of information.

10-03-2003

| Patent document cited in search report | Publication date | Patent family member(s) | Publication date |
|---|---|---|---|
| EP 1047117 A | 25-10-2000 | JP 3350478 B2 | 25-11-2002 |
| | | JP 2000307082 A | 02-11-2000 |
| | | EP 1047117 A2 | 25-10-2000 |
| | | TW 469498 B | 21-12-2001 |
| | | US 6319763 B1 | 20-11-2001 |
| US 4239811 A | 16-12-1980 | AT 13076 T | 15-05-1985 |
| | | CA 1166128 A1 | 24-04-1984 |
| | | DE 3070578 D1 | 05-06-1985 |
| | | EP 0024305 A1 | 04-03-1981 |
| | | IT 1150033 B | 10-12-1986 |
| | | JP 1496848 C | 16-05-1989 |
| | | JP 56027937 A | 18-03-1981 |
| | | JP 63041214 B | 16-08-1988 |
| EP 0260473 A | 23-03-1988 | US 4725560 A | 16-02-1988 |
| | | DE 3774052 D1 | 28-11-1991 |
| | | EP 0260473 A1 | 23-03-1988 |
| | | JP 63069238 A | 29-03-1988 |

EPO FORM P0459

For more details about this annex : see Official Journal of the European Patent Office, No. 12/82